# EUROPEAN PATENT APPLICATION

(11) **EP 2 099 067 A1**
(43) Date of publication of application: **09.09.2009**
(21) Application number: 08152451.4
(22) Date of filing: 07.03.2008
(51) Int. Cl.: H01L 21/687, H01L 41/09, F16D 27/00

(54) **Process for adjusting the friction coefficient between surfaces of two solid objects**

(71) Applicant: Nederlandse Organisatie voor Toegepast- Natuurwetenschappelijk Onderzoek TNO, 2628 VK The Hague (NL)
(72) Inventor: Dillingh, Elbert Christiaan, 2642 DR Pijnacker (NL); Hermse, Chrétien, Guillaume, Maria, 5664 PS Geldrop (NL); Huis in't Veld, Albertus, Josef, 5581 JG Waalre (NL)
(74) Representative: Hatzmann, Martin

(57) **Abstract**

The invention provides a process for adjusting the friction coefficient and adhesion between a surface of a first solid object and a surface of a second solid object, which surfaces are movable with respect to each other when the solid objects are in contact with each other, wherein the surface roughness of at least one of the surfaces is adjusted by subjecting one or more selected parts of at least one of the objects to an external stimulus, which selected parts comprise a material which expands or changes in volume when the selected parts are subjected to the external stimulus. The invention further provides an object having a surface of which the roughness can be adjusted by subjecting one or more selected parts of the object to an external stimulus, which selected parts comprise a material which expands or changes in volume when the selected parts are subjected to the external stimulus. In addition, the invention provides a system comprising said object.

## Description

The present invention relates to a process for adjusting the friction coefficient between a surface of a first solid object and a surface of a second solid object.

It is well appreciated that the manufacture of high-end products such as semi-conductors and optical systems requires the use of equipment wherein use is made of very flat and smooth surfaces. For instance, in the manufacture of semi-conductors, the surface of a silicon wafer and a wafer-handling surface need to be very flat and smooth. The use of very flat and smooth surfaces has, however, the disadvantage that after use the silicon wafer and wafer-handling surface can only be separated by means of high mechanical force due to the high surface adhesive forces between the surfaces (Van der Waals forces). As a result of the high mechanical force that is required to separate both surfaces, the surfaces can be damaged which affects the reproducibility of the high-end equipment used.
Moreover, it is difficult to position objects relative to each other once they have touched, without physically separating the two objects again.

Object of the present invention is to provide an improved process and system for the production of high-end products that attractively deals with the above-mentioned problems.

Surprisingly, it has now been found that this can be established when the friction coefficient between the surfaces is adjusted by means of a material having a surface roughness that changes when the material is subjected to an external stimulus.

Accordingly, the present invention relates to a process for adjusting the friction coefficient between a surface of a first solid object and a surface of a second solid object, which surfaces are movable with respect to each other when the solid objects are in contact with each other, wherein the surface roughness of at least one of the surfaces is adjusted by subjecting one or more selected parts of at least one of the objects to an external stimulus, which selected parts comprise a material which expands or changes in volume when the selected parts are subjected to the external stimulus.

In accordance with the present invention the surface of a silicon wafer and a wafer-handling surface can very easily be separated from each other after use, thus avoiding that the surfaces will be damaged and ensuring an attractive reproducibility of the high-end system over a longer period of time. It also enables easier positioning of the silicon wafer and the wafer-handling surface with respect to each other.

Suitably, the material that expands or changes in volume when the selected parts are subjected to the external stimulus is selected from the group consisting of piezo-electric materials, metal alloys, shape memory alloys, magnetostrictive materials and polymers.

Suitable examples of piezo-electric materials include lead zirconate titanate (PZT), lead magnesium niobate (PMN), lead niobate (LMN), lead titanate (PT), bismuth titanate, barium titanate, lead metaniobate, potassium niobate, lithium niobate, lithium tantalate, sodium tungstate and polyvinylidene fluoride (PVFD). Preferably the piezo-electric material is PZT or PVFD. More preferably, the piezo-electric material is PZT.

Suitable examples of shape memory metal alloys include, copper-zinc-aluminium-nickel, copper-aluminium-nickel, nickel-titanium (NiTi) alloys. Preferably, the shape memory alloy is copper-zinc-aluminium-nickel or NiTi. More preferably, the shape memory alloy is copper-zinc-aluminium-nickel.

Preferably, the metal alloy is an iron-nickel-chromium-molybdenum alloy or an iron-aluminium-chromium-molybdenum alloy. More preferably, the metal alloy is a iron-nickel-chromium-molybdenum alloy.

Suitable examples of magnetostrictive materials are iron, cobalt, nickel and terfenol-D. Preferably the magnetostrictive material is terfenol-D.

Suitable examples of polymers are polyethylene, polypropylene, polyvinylchloride, poly urethane, polyethyleneterephtalate, polyester, polyamines.

Preferably, the polymer is polyethylene.

Preferably, the material that expands or changes in volume when the selected parts are subjected to the external stimulus is a piezo-electric material.

In accordance with the present invention suitably one or more selected parts of one of the objects are subjected to an external stimulus.

Preferably, two or more selected parts of at least one of the objects are subjected to an external stimulus.

Suitably, the material has the form of a uniform layer within at least one of the objects which layer is arranged near the surface of the at least one object.

The external stimulus to be used in accordance with the present invention is suitably heat, electro-magnetic radiation, a magnetic field or an electric field.

Preferably, the external stimulus is heat or an electric field.

More preferably, the external stimulus is an electric field.

Suitably, in the process of the present invention the surface roughness of at least one of the surfaces increases.

Preferably, the surface roughness of only one of the surfaces increases.

In accordance with the present invention the objects have a multi-layer structure wherein at least one of the layers comprises the material that expands or changes in volume when the selected parts are subjected to the external stimulus.

In a particularly attractive embodiment of the invention the adjustment of the friction coefficient between the surfaces of the first and second object is reversible, establishing an attractive reproducibility over a prolonged period of time.

In another very attractive embodiment of the present invention the adjustment of the friction coefficient is directionally dependent. This means that objects can be aligned in one direction while maintaining relative orientation in the other direction.

Suitably, at least one or more selected parts of at least the second object are subjected to the external stimulus.

Suitably, in accordance with the present invention, the first object is a silicon wafer and the second object is a wafer-handling surface.

Other suitable first objects include reticles (masks) and wafers.

Other suitable second objects include reticle clamps and wafer clamps.

The present invention also provides a solid object having a surface of which the roughness can be adjusted by subjecting one or more selected parts of the object to an external stimulus, which selected parts comprise a material which expands or changes in volume when the selected parts are subjected to the external stimulus.

Preferably, the surface roughness of the surface of the object increases.

In accordance with the present invention the object has preferably a multi-layer structure wherein at least one of the layers comprises the material that expands or changes in volume when the selected parts are subjected to the external stimulus.

Preferably, the material has the form of a uniform layer within the object which layer is arranged near the surface of the object.

In a particularly attractive embodiment of the invention, the adjustment of the roughness of the surface of the object is reversible.

In another very attractive embodiment of the present invention, the adjustment of the friction coefficient is directionally dependent.

Preferably, the object is a wafer-handling surface.

The present invention further provides a system that comprises two or more objects of which at least one object is the object in accordance with the present invention.

Preferably, the system in accordance with the present invention comprises a high-end equipment system that comprises a silicon wafer and a wafer-handling surface in accordance with the present invention.

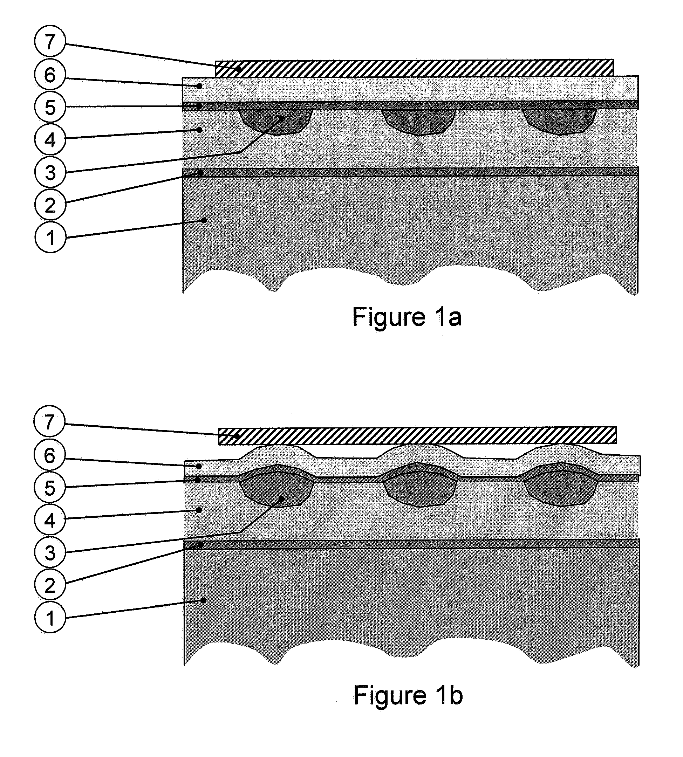

The invention will now be illustrated by means of Figure 1 wherein (1) is the substrate of the clamp, (2) and (5) are respectively the lower and upper electrode which span an electric field over the PZT material (3) and (4). The PZT-material is divided into two phases, (3) is the poled PZT-material and (4) is the unpoled PZT-material. The multi-layer can optionally finish with a top coating (6). Finally (7) is the object being clamped. In Figure 1 two clamp states are shown. Figure 1a shows the clamped condition while Figure 1b shows the unclamped/released and/or low friction condition.

## Claims

1. A process for adjusting the friction coefficient between a surface of a first solid object and a surface of a second solid object, which surfaces are movable with respect to each other when the solid objects are in contact with each other, wherein the surface roughness of at least one of the surfaces is adjusted by subjecting one or more selected parts of at least one of the objects to an external stimulus, which selected parts comprise a material which expands or changes in volume when the selected parts are subjected to the external stimulus.

2. The process according to claim 1, wherein the material which expands or changes in volume when the selected parts are subjected to the external stimulus is selected from the group consisting of piezo-electric materials, metal alloys, shape memory alloys, magnetostrictive materials and polymers.

3. The process according to claim 2, wherein the material is a piezo-electric material.

4. The process according to any one of claims 1-3, wherein one or more selected parts of one of the objects are subjected to an external stimulus.

5. The process according to any one of claims 1-4, wherein two or more selected parts of at least one of the objects are subjected to an external stimulus.

6. The process according to any one of claims 1-5, wherein the material has the form of a uniform layer within at least one of the objects which layer is arranged near the surface of the at least one object.

7. The process according to any one of claims 1-5, wherein the external stimulus is heat, electro-magnetic radiation, a magnetic field or an electric field.

8. The process according to claim 7, wherein the external stimulus is heat or an electric field.

9. The process according to any one of claims 1-8, wherein the surface roughness of at least one of the surfaces increases.

10. The process according to any one of claims 1-9, wherein the objects have a multi-layer structure wherein at least one of the layers comprises the material which expands or changes in volume when the selected parts are subjected to the external stimulus.

11. The process according to any one of claims 1-10, wherein the adjustment of the friction coefficient between the surfaces of the first and second object is reversible.

12. The process according to any one of claims 1-11, wherein the adjustment of the friction coefficient is directionally dependent.

13. The process according to any one of claims 1-12, wherein the first object is a silicon wafer and the second object is a wafer-handling surface.

14. The process according to claim 13, wherein at least one or more selected parts of at least the second object are subjected to the external stimulus.

15. A solid object having a surface of which the roughness can be adjusted by subjecting one or more selected parts of the object to an external stimulus, which selected parts comprise a material which expands or changes in volume when the selected parts are subjected to the external stimulus.

16. The object according to claim 15, wherein the material which expands or changes in volume when the selected parts are subjected to the external stimulus is selected from the group consisting of piezo-electric materials, metal alloys, shape memory alloys, magnetostrictive materials and polymers.

17. The object according to claim 16, wherein the material is a piezo- electric material.

18. The object according to any one of claims 15-17, wherein the roughness of the surface of the object increases.

19. The object according to any one of claims 15-18, wherein the object has a multi-layer structure wherein at least one of the layers comprises the material that expands or changes in volume when the selected parts are subjected to the external stimulus.

20. The object according to any one of claims 15-19, wherein the material has the form of a uniform layer within the object which layer is arranged near the surface of the object.

21. The object according to any one of claims 15-20, which object is a wafer-handling surface.

22. A system that comprises two or more objects of which at least one object is the object as defined in any one of claims 15-20.

23. The system according to claim 22, which system is a high-end equipment system that comprises a silicon wafer and a wafer-handling surface, which wafer handling surface is defined in claim 20.
